# EUROPÄISCHE PATENTSCHRIFT

(11) **EP 0 736 977 B1**
(45) Veröffentlichungstag und Bekanntmachung des Hinweises auf die Patenterteilung: **12.09.2001**
(21) Anmeldenummer: 96104244.7
(22) Anmeldetag: 18.03.1996
(51) Int. Cl.: H03M 1/10, H03M 1/46

(54) **Verfahren zur Selbstkalibrierung eines A/D- oder D/A-Wandlers**
Method for the autocalibration of an AD or DA converter
Procédé d'autocalibrage d'un convertisseur analogique-numérique ou d'un convertisseur numérique-analogique

(30) Priorität: 04.04.1995 DE 19512495
(43) Veröffentlichungstag der Anmeldung: 09.10.1996
(73) Patentinhaber: Infineon Technologies AG, 81669 München (DE)
(72) Erfinder: Kuttner, Franz, Dipl.-Ing., 9524 St. Ulrich (DE)
(74) Vertreter: Zedlitz, Peter, Dipl.-Inf.

(56) Entgegenhaltungen:
- EP-A- 0 064 147
- EP-A- 0 360 914
- EP-A- 0 360 922
- GB-A- 2 184 621
- LEE, HAE-SUNG; HODGES, DAVID A.: "Self-Calibration Technique for A/D Converters", IEEE TRANSACTIONS ON CIRCUITS AND SYSTEMS, NEW YORK, USA, 01. Maerz 1999, Band 30, Nr. 3, Seiten 188 - 190

## Beschreibung

Die Erfindung betrifft ein Verfahren zur Selbstkalibrierung eines Analog/Digital-Wandlers oder eines Digital/Analag-Wandlers nach dem Oberbegriff des Patentanspruchs 1.

Bei A/D- oder D/A-Wandlern werden Referenzelemente verwendet, um in Abhängigkeit von einem zu wandelnden Eingangssignal Referenzsignale abzuleiten, mit denen in Vergleichsvorgängen die Umsetzung auf das digitale bzw. analoge Ausgangssignal durchgeführt wird. Sie bilden ein gewichtetes Netzwerk. Die Referenzelemente sind beispielsweise als Widerstände, Kondensatoren oder Transistoren ausgeführt. Das Verhältnis, in welchem die von den gewichteten Referenzelementen erzeugten Referenzgrößen zueinander stehen, beeinflußt die Genauigkeit des Wandlers.

Um herstellungsbedingte Ungenauigkeiten der Gewichtungsverhältnisse der Referenzelemente zu verbessern, werden Selbstkalibrierungsverfahren verwendet. Ein Selbstkalibrierungsverfahren, das für A/D-Wandler, die nach dem Prinzip der sukzessiven Approximation mit Ladungsumverteilung an einem gewichteten Kapazitätsnetzwerk arbeiten, geeignet ist, ist in der Veröffentlichung H.-S. Lee und D. A. Hodges, "Self-Calibration Technique for A/D Converters", IEEE Transactions on Circuits and Systems, Band CAS-30, Nr. 3, März 1983, Seiten 188 bis 190 beschrieben. Ein ähnliches Verfahren ist in der US-Patentschrift Nr. 4 399 426 (Tan) beschrieben. Bei diesen Selbstkalibrierungsverfahren ist neben dem für die Wandlung bestimmten Hauptkapazitätsnetzwerk ein Korrekturkapazitätsnetzwerk vorgesehen, durch das Linearitätsfehler des Hauptkapazitätsnetzwerk korrigiert werden. Dem Korrekturnetzwerk ist ein Speicher zugeordnet, der die Korrekturwerte, durch welche die Korrekturkapazitäten angesteuert werden, enthält, so daß Linearitätsfehler möglichst ausgeglichen werden. Durch das Selbstkalibrierungsverfahren werden die Korrekturwerte ermittelt. Bei dieser Selbstkalibrierung wird der Kapazitätswert eines Referenzelements des Hauptnetzwerks mit der Summe der Kapazitätswerte der niedrigerwertigen Referenzelemente verglichen. Dies erfolgt durch Ladungsumverteilung von diesem Referenzelement auf die jeweils niedrigerwertigen Referenzelemente und Auswertung der Spannungsänderung. Auf diese Weise wird schrittweise für jedes Referenzelement die Abweichung von einer idealen Gewichtung festgestellt und daraus ein Korrekturwert für jedes Referenzelement ermittelt. Die Kalibrierung wird dabei während eines Selbstkalibrierungszykluses vollständig durchgeführt, so daß die Korrekturwerte für die nachfolgenden Wandlungsvorgänge unverändert verwendet werden. Zweckmäßigerweise wird bei Lee und Hodges vorgeschlagen, die Selbstkalibrierung nach dem Einschalten während des Power-On durchzuführen.

Solche Wandler mit Selbstkalibrierung können zusammen mit anderen, vorzugsweise zeitdiskret und digital arbeitenden Schaltungseinrichtungen auf einem einzigen integrierten Halbleiterchip realisiert werden. Beispielsweise können solche Chips Microcontroller sein, die einen digital arbeitenden, taktgesteuerten Prozessor enthalten, dem Analogsignale über eine A/D-Wandlerschnittstelle zuführbar sind. Dies liegt beispielsweise beim integrierten Schaltkreis SAB 80C166 der Firma Siemens vor. Durch das taktgesteuerte Arbeiten des Prozessors können auf den Signal- und Versorgungsspannungsleitungen Störimpulse erzeugt werden. Diese Störungen überlagern sich dem vom A/D-Wandler erzeugten Ausgangssignal als unkorreliertes Rauschen, das stochastisch verteilt ist, oder als Signal-Offset, der die synchron zur Abtastrate des Wandlers auftretenden Störungen enthält. Durch diese Störungen werden ebenfalls die Meßergebnisse beim Selbstkalibrierungsvorgang beeinflußt. Die Genauigkeit der Kalibrierung kann dadurch verringert werden. In besonders gelagerten Fällen können diese Störungen sogar dazu führen, daß die durch die Kalibrierung erzeugte Korrektur mitkoppelnd wirkt, so daß in die falsche Richtung korrigiert wird und die Genauigkeit des Wandlers erheblich verringert wird.

In der GB 2 184 621 A ist ein Verfahren zur Selbstkalibrierung eines A/D-Wandlers beschrieben, bei dem für jeden Referenzkondensator Kalibriedrungsvorgänge zur Einstellung von jeweils zugeordneten Korrekturkapazitäten durchgeführt werden. Die Korrekturkapazitäten werden in größenmäßiger Reihenfolge kalibriert. Nach Abschluß aller einem der Referenzkondensatoren zugeordneten Korrekturkapazitäten wird mit der Kalibrierung der Korrekturkapazitäten für den nächstgrößeren Referenzkondensator fortgefahren. Alle Einzelkalibrierungen können entweder zusammenhängend durchgeführt werden oder abwechselnd mit je einem Wandlungszyklus.

Der Erfindung liegt die Aufgabe zugrunde, ein Verfahren zur Selbstkalibrierung eines Analog/Digital-Wandlers oder eines Digital/Analog-Wandlers anzugeben, das weniger störanfällig ist.

Erfindungsgemäß wird diese Aufgabe durch die kennzeichnenden Merkmale des Patentanspruchs 1 gelöst.

Durch das erfindungsgemäße Verfahren ist die Selbstkalibrierung gegenüber während des Kalibrierungsvorgangs auftretenden Störungen, die beispielsweise durch taktgesteuert arbeitende Schaltungseinheiten erzeugt werden können, relativ unempfindlich. Das Verfahren ist insbesondere für einen Wandler geeignet, der zusammen mit anderen Schaltungseinheiten auf einem integrierten Schaltungschip angeordnet ist. Der während zweier Wandlungen durchzuführende Verfahrensabschnitt der Selbstkalibrierung benötigt nur eine kurze Zeit, so daß die Kalibrierung für einen Anwender des Wandlers unbemerkt im Hintergrund abläuft. Die Verfügbarkeit des Wandlers wird kaum beeinträchtigt und die Wandlungsgeschwindigkeit nicht beeinflußt. In Ausgestaltung des erfindungsgemäßen Verfahrens werden sowohl zufällig auftretende Störungen sowie synchrone Störungen (Offset) zufriedenstellend korrigiert. Das Verfahren kann bei dem bekannten Selbstkalibrierungsverfahren für A/D-Wandler mit Ladungsumverteilung und sukzessiver Approximation ohne zusätzlichen Hardwareaufwand nur durch Modifikation der Steuerung realisiert werden.

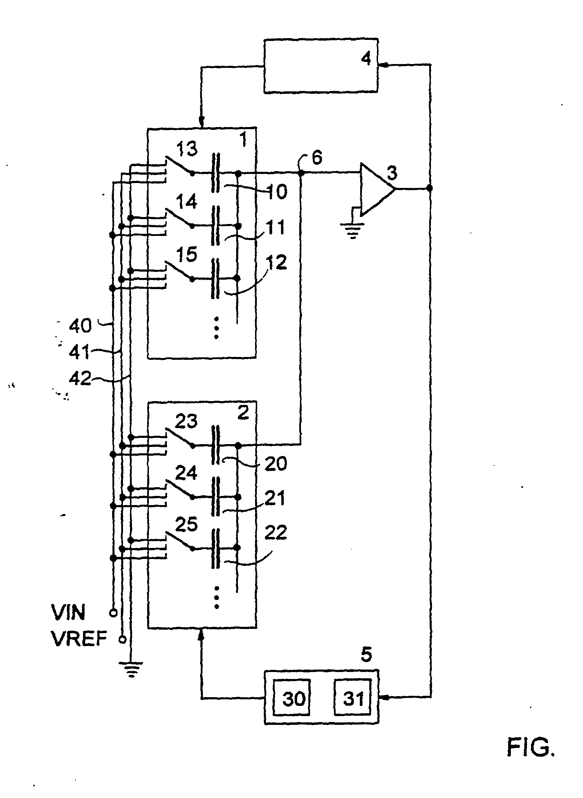

Nachfolgend wird die Erfindung am Beispiel des in der Figur dargestellten A/D-Wandlers nach dem Prinzip der Ladungsumverteilung und der sukzessiven Approximation detaillierter beschrieben.

Der A/D-Wandler der Figur enthält ein Hauptkapazitätsnetzwerk 1 sowie ein Korrekturnetzwerk 2. Beide Netzwerke sind an einem Knoten 6 miteinander ausgangsseitig gekoppelt. Das am Knoten 6 anliegende Signal wird in einem Komparator 3 mit einer Referenzspannung verglichen, und abhängig davon wird eine Steuerungseinrichtung 4 für das Hauptkapazitätsnetzwerk 1 bzw. eine Steuerung 5 für das Korrekturnetzwerk 2 angesteuert.

Das Hauptkapazitätsnetzwerk 1 enthält eine Vielzahl von binär gewichteten Kapazitäten, von denen nur die höchstwertigen Kapazitäten 10, 11, 12 dargestellt sind. Über jeweilige Schalter 13, 14, 15 sind die gewichteten Kapazitäten entweder mit Massepotential, einem Referenzpotential VREF oder dem Eingangssignal VIN verbindbar. Die Steuerung der Schalter und die davon abhängige Auswertung des Spannungssignals am Knoten 6 wird durch die Steuerungseinrichtung 4 durchgeführt. Die Wandlung des analogen Eingangssignal VIN in ein digitales Ausgangssignal, das in der Einrichtung 4 vorliegt, wird nach dem Prinzip der Ladungsumverteilung und der sukzessiven Approximation durchgeführt, wie dies in der US-Patentschrift Tan ausführlich beschrieben ist. Hierzu werden die Kondensatoren des gewichteten Netzwerks 1 zuerst mit dem Eingangssignal VIN aufgeladen, wobei der Knoten 6 geerdet ist (Abtastung des Eingangssignal VIN). Anschließend wird sukzessiv jeder der Schalter 13, 14, 15 sowohl mit dem Referenzpotential VREF als auch mit Massepotential verbunden. In Abhängigkeit vom Vergleichsergebnis im Komparator 3 wird der sich ergebende Digitalwert in einem Register der Steuerungseinrichtung 4 gespeichert.

In der Steuerungseinrichtung 5 ist eine Speichereinrichtung 30 vorgesehen, die für jedes der Referenzelemente 10, 11, 12 einen Korrekturwert enthält. Dieser Korrekturwert sorgt dafür, daß dann, wenn zur sukzessiven Approximation einer der Kondensatoren 10, 11, 12 des Hauptnetzwerks 1 für den Vergleichsvorgang aktiviert ist, am Knoten 6 ein durch das Korrekturnetzwerk 2 erzeugtes Korrektursignal eingespeist wird, so daß der Fehler des des jeweiligen Kondensators des Netzwerks 1 ausgeglichen wird. Die erforderlichen Schaltereinstellungen der Schalter 23, 24, 25 des Korrekturnetzwerks 2 werden durch den im Speicher 30 der Steuerungseinrichtung 5 gespeicherten Korrekturwert festgelegt. Insoweit entspricht die Betriebsweise des in der Figur dargestellten A/D-Wandlers den Darstellungen in den eingangs genannten Dokumenten Tan und Lee/Hodges.

Die Erfindung geht davon aus, daß im Korrekturspeicher 30 bereits Korrekturwerte für jedes der Referenzelemente 10, 11, 12 gespeichert sind. Diese können durch einen Kalibrierungsvorgang während der Einschaltphase ermittelt worden sein. Zwischen aufeinanderfolgenden Wandlungsvorgängen für zwei Abtastwerte des Eingangssignals VIN wird erfindungsgemäß ein Selbstkalibrierungsvorgang durchgeführt. Dabei wird nur für eines der Referenzelemente 10, 11, 12 in Abhängigkeit vom Vergleichsergebnis des Komparators 3 der für dieses Referenzelement bereits vorliegende Korrekturwert entweder um eine vorgegebene Schrittweite erhöht oder verringert. Zweckmäßigerweise beträgt diese Schrittweite +/-1 LSB (LSB: niedrigstwertiges Bit des Korrekturwerts). Nach einer darauffolgenden Wandlung wird ein weiterer solcher Selbstkalibrierungsvorgang durchgeführt. Dabei wird der Selbstkalibrierungsvorgang auf ein anderes der Referenzelemente 10, 11, 12 angewandt, zweckmäßigerweise das nächst niedriger oder höher gewichtete Referenzelement. Wiederum wird dessen bereits vorliegender Korrekturwert in Abhängigkeit vom Ergebnis des Komparators 3 um +/-1 LSB verändert. Für ein Netzwerk mit n Referenzelementen 10, 11, 12 wird also nach jeder n-ten Wandlung der Korrekturwert nachgestellt. Die entsprechende Zeitsteuerung wird vom Steuerungsteil 31 der Steuerungseinrichtung 5 durchgeführt.

Wenn bei einer Kalibrierung zwischen zwei Wandlungen eine Störung auftritt, wird das Vergleichsergebnis im Komparator 3 beeinflußt und gegebenenfalls auch verfälscht. Der dazugehörige Korrekturwert wird folglich in die falsche Richtung um +/-1 LSB verändert. Erfahrungsgemäß ist aber in praktischen Fällen beim nächsten Durchlauf nach n-Wandlungen diese Störung abgeklungen, soweit sie zufällig auftritt und stochastisch möglichst gleichverteilt ist. Dann wird der Korrekturwert wieder in die richtige Richtung verändert. Bei zufälligen Störungen führt dieses Selbstkalibrierungsverfahren folglich dazu, daß die Korrekturwerte um ihren Sollkorrekturwert pendeln und der Kalibrierungsfehler trotz der gestörten Umgebung hinreichend klein bleibt.

Prinzipiell werden zwischen zwei Wandlungsvorgängen die folgenden Selbstkalibrierungsschritte für jedes der Referenzelement durchgeführt. Das Hauptkapazitätsnetzwerk des Wandlers wird derart eingestellt, daß der zu kalibrierende Referenzkondensator an die eine Referenzspannung gelegt wird, die niedriger gewichteten Referenzkondensatoren an die andere Referenzspannung. Das Korrekturnetzwerk ist dabei aktiviert und berücksichtigt den bereits vorliegenden Korrekturwert. Anschließend werden die Referenzspannungen an den Kondensatoren umgekehrt. Je nach dem Ergebnis des Vergleichers 3 wird dann der Korrekturwert um +/-1 LSB verändert. Diese Verfahrensschritte werden zwischen zwei weiteren aufeinanderfolgenden Wandlungen wiederholt, wobei jeweils ein anderers Referenzelement kalibriert wird.

Während wie bisher beschrieben, zufällige Störungen in Form von Rauschen die Linearität des Hauptkorrekturnetzwerks beeinflussen, sorgen synchron zur Abtastrate des Wandlers auftretende Störungen zu einem Versatz (Offset) des digital gewandelten Ausgangsergebnisses des Wandlers. Um eine synchrone Störung auszugleichen, wird ein zusätzlicher Kalibrierungsvorgang durchgeführt, nachdem alle Referenzelemente einzeln wie oben beschrieben im Hinblick auf die Linearität abgeglichen wurden. Bei der Offset-Kalibrierung wird nur diese Offset-Störung ermittelt und ausgeglichen. Der Offset setzt sichaus einem statischen Anteil, der durch den Komparator erzeugt wird, und aus synchronen Störungen, die den Signalen des Wandlers überlagert werden, zusammen. Diese synchronen Störungen können beispielsweise Spannungs- und Stromimpulse auf den Versorgungs- und Signalleitungen sein, die durch das synchrone, taktgesteuerte Schalten von digitalen Schaltungseinrichtungen, die zusammen mit dem A/D-Wandler auf einem integrierten Schaltkreis realisiert sind, erzeugt werden. Bei der Offset-Kalibrierung wird der Offset mit einem bereits im Speicher 30 vorliegenden Korrekturwert verglichen und der Korrekturwert wird anschließend um +/-1 LSB erhöht oder verringert. Somit pendelt der Korrekturwert für den Offset um den Korrektursollwert. Außerdem kann der Offset einer langsamen Veränderung, die beispielsweise durch Temperaturänderungen hervorgerufen wird, nachgeführt werden.

Bei der Offset-Kalibrierung wird nur die durch den Offset hervorgerufene Störung ermittelt. Hierzu wird zweckmäßigerweise eine Wandlung mit dem bereits vorliegenden Offset-Korrekturwert durchgeführt. Wenn der bereits vorliegende Korrekturwert richtig ist und den Offset exakt ausgleicht, dann befindet sich der Komparator 3 genau in seiner Entscheidungsschwelle. Dies bedeutet, daß der Komparator 3 mit gleicher Wahrscheinlichkeit einen seiner beiden Ausgangszustände einnimmt. In Abhängigkeit von diesem Komparatorergebnis wird nun der Korrekturwert um +/-1 LSB verändert. Der Korrekturwert pendelt dann nahe um den Sollkorrekturwert. Weicht der Korrekturwert vom tatsächlich vorliegende Offset-Wert in höherem Maße ab, wird je nach Abweichungsrichtung mehrfach mit +/-1 LSB nachgestellt (wobei nur ein Nachstellvorgang mit +/-1 LSB zwischen zwei Wandlungen erfolgt), so daß der Korrektursollwert nach mehreren Offset-Selbstkalibrierungsvorgängen erreicht wird und der Offset exakt ausgeglichen wird. Wenn der Korrekturwert beispielsweise 8 Bit Wortbreite umfaßt und somit einen Kalibrierbereich von +/-128 umfaßt, wird der Sollkorrekturwert im ungünstigsten Fall nach 128 Durchläufen erreicht.

Durch die inkrementelle Veränderung von +/-1 LSB für den Korrekturwert der Offset-Kalibrierung und die Korrekturwerte der Linearitätskalibrierung für die einzelnen Referenzelemente wird eine Tiefpaßeigenschaft der Kalibrierung erreicht. Kurzzeitige Störeinflüsse wirken sich kaum aus. Rauschen wird demnach während der Kalibrierung gefiltert.

Beim Einschalten des A/D-Wandlers bzw. bei einem Reset werden zweckmäßigerweise alle Korrekturwerte im Speicher 30 mit Null vorbesetzt. Für eine anschließende Anzahl von Selbstkalibrierungsvorgängen wird dann eine erhöhte Schrittweite von beispielsweise +/-15 LSB vorgesehen. Für eine nachfolgende Anzahl von Selbstkalibrierungsvorgängen wird eine etwas verringernde Schrittweite von beispielsweise +/-7 LSB vorgesehen, für eine wiederum weitere Anzahl von Selbstkalibrierungsvorgängen eine Schrittweite von +/-3 LSB. Erst dann wird bei jedem Kalbrierungsvorgang wie oben beschrieben die Schrittweite von +/-1 LSB benutzt. Dadurch wird erreicht, daß beim Einschalten oder bei einem Reset der eingeschwungene Zustand der Sollkorrekturwerte relativ schnell erreicht wird. Die anfänglichen Wandlungen werden dann aber mit geringerer Genauigkeit durchgeführt.

## Patentansprüche

1. Verfahren zur Selbstkalibrierung eines Analog-Digital-Wandlers oder eines Digital-Analog-Wandlers, bei dem der Wandler mindestens ein Hauptnetzwerk (1) mit gewichteten Referenzelementen (10, 11, 12) enthält und ein mit dem Hauptnetzwerk (1) zur Fehlerkorrektur gekoppeltes Korrekturnetzwerk (2) mit gewichteten weiteren Referenzelementen (20, 21, 22), bei dem den Referenzelementen (10, 11, 12) des Hauptnetzwerks (1) Korrekturwerte zur Steuerung des Korrekturnetzwerks (2) zugeordnet sind, zwischen zwei Wandlungen ein Selbstkalibrierungsvorgang für ein Referenzelement des Hauptnetzwerks (1) durchgeführt wird und ein diesem Referenzelement zugeordneter Korrekturwert ermittelt wird,
**dadurch gekennzeichnet, daß**
der Korrekturwert bei jedem Selbstkalibrierungsvorgang derart ermittelt wird, daß ein für das jeweilige Referenzelement bereits vorliegender Korrekturwert einmal um eine festgelegte Schrittweite verändert wird und daß jeweils zwei unmittelbar nacheinander folgende Selbstkalibrierungsvorgänge stets auf verschiedene Referenzelemente angewandt werden.

2. Verfahren nach Anspruch 1,
**dadurch gekennzeichnet, daß**
nach einer Folge von Selbstkalibrierungsvorgängen für die Referenzelemente des Hauptnetzwerks ein Offsetkalibrierungsvorgang durchgeführt wird, bei dem ein bereits vorliegender Korrekturwert für die Offsetkalibrierung einmal um eine festgelegte Schrittweite verändert wird.

3. Verfahren nach Anspruch 1 oder 2,
**dadurch gekennzeichnet, daß**
die festgelegte Schrittweite 1 LSB ist, wobei 1 LSB das niedrigstwertigste Bit des jeweiligen Korrekturwerts ist.

4. Verfahren nach einem der Ansprüche 1 bis 3,
**dadurch gekennzeichnet, daß**
zuerst die Korrekturwerte mit Null vorbesetzt sind, dann für eine Anzahl von Kalibrierungsvorgängen die festgelegte Schrittweite größer als 1 LSB ist und danach die Schrittweite 1 LSB ist, wobei 1 LSB das niedrigstwertigste Bit des jeweiligen Korrekturwerts ist.

5. Verfahren nach einem der Ansprüche 2 bis 4,
**dadurch gekennzeichnet, daß**
für einen Selbstkalibrierungsvorgang ein von einem Referenzelement abgeleitetes charakteristisches Signal mit einem aus den Referenzelementen niedriger Gewichtung gebildeten Signal unter Berücksichtigung des vom Korrekturwert für das Referenzelement gesteuerten Korrekturnetzwerks verglichen wird und daß in Abhängigkeit vom Vergleichsergebnis der Korrekturwert um die festgelegte Schrittweite verändert wird.

6. Verfahren nach einem der Ansprüche 2 bis 4,
**dadurch gekennzeichnet, daß**
für einen Offsetkalibrierungsvorgang ein aus dem für die Offsetkalibrierung vorgesehenen Korrekturwert abgeleitetes Signal mit einem vom momentan vorliegenden Offset abgeleiteten Signal verglichen wird und in Abhängigkeit vom Wandlungsergebnis der Korrekturwert um die festgelegte Schrittweite verändert wird.

7. Verfahren nach einem der vorhergehenden Ansprüche,
**dadurch gekennzeichnet, daß**
der Wandler nach dem Prinzip der Ladungsumverteilung mit sukzessiver Approximation arbeitet und ein binär gewichtetes Kapazitätshauptnetzwerk (1) und ein binär gewichtetes Kapazitätskorrekturnetzwerk (2) enthält.

## Claims

1. Method for self-calibration of an analogue/ digital converter or of a digital/analogue converter, in which the converter contains at least one main network (1) having weighted reference elements (10, 11, 12) and contains a correction network (2), coupled to the main network (1) for the purpose of error correction, having weighted further reference elements (20, 21, 22), in which the reference elements (10, 11, 12) in the main network (1) have associated correction values for controlling the correction network (2), a self-calibration operation for a reference element in the main network (1) is carried out between two conversions, and a correction value associated with this reference element is ascertained,
**characterized in that**
the correction value for each self-calibration operation is ascertained such that a correction value already present for the respective reference element is changed once by a stipulated step size and in that two respective directly consecutive self-calibration operations are always applied to different reference elements.

2. Method according to Claim 1,
**characterized in that**,
after a series of self-calibration operations for the reference elements in the main network, an offset calibration operation is carried out, in which an already present correction value for the offset calibration is changed once by a stipulated step size.

3. Method according to Claim 1 or 2,
**characterized in that**
the stipulated step size is 1 LSB, 1 LSB being the least significant bit of the respective correction value.

4. Method as claimed in one of Claims 1 to 3,
**characterized in that**
the correction values are first assigned a preliminary value of zero, the stipulated step size is then greater than 1 LSB for a number of calibration operations, and thereafter the step size is 1 LSB, 1 LSB being the least significant bit of the respective correction value.

5. Method according to one of Claims 1 to 4,
**characterized in that**,
for a self-calibration operation, a characteristic signal derived from a reference element is compared with a signal formed from the reference elements with a lower weighting, taking into account the correction network controlled by the correction value for the reference element, and in that the correction value is changed by the stipulated step size on the basis of the comparison result.

6. Method according to one of Claims 2 to 4,
**characterized in that**,
for an offset calibration operation, a signal derived from the correction value provided for the offset calibration is compared with a signal derived from the offset which is currently present, and the correction value is changed by the stipulated step size on the basis of the conversion result.

7. Method according to one of the preceding claims,
**characterized in that**
the converter operates on the basis of charge redistribution with successive approximation and contains a capacitance main network (1) with binary weighting and a capacitance correction network (2) with binary weighting.

## Revendications

1. Procédé pour l'autocalibrage d'un convertisseur analogique-numérique ou d'un convertisseur numérique-analogique, dans lequel le convertisseur contient au moins un réseau principal (1) comportant des éléments de référence pondérés (10, 11, 12) et un réseau correcteur (2) couplé au réseau principal (1) en vue de la correction d'erreur et comportant d'autres éléments de référence pondérés (20, 21, 22) et dans lequel on associe aux éléments de référence (10, 11, 12) du réseau principal (1) des valeurs correctrices pour la commande du réseau correcteur (2), on effectue entre deux conversions une opération d'autocalibrage pour un élément de référence du réseau principal (1) et on détermine une valeur correctrice associée à cet élément de référence,
**caractérisé par** le fait qu'on détermine la valeur correctrice lors de chaque opération d'autocalibrage de telle sorte qu'une valeur correctrice déjà présente pour l'élément de référence respectif est modifiée une fois d'un pas fixé et que, à chaque fois, deux opérations d'autocalibrage qui se suivent directement sont toujours appliquées à des éléments de référence différents.

2. Procédé selon la revendication 1,
**caractérisé par** le fait que, après une suite d'opérations d'autocalibrage, on effectue pour les éléments de référence du réseau principal une opération de calibrage d'offset dans laquelle une valeur correctrice déjà présente est modifiée une fois d'un pas fixé pour le calibrage d'offset.

3. Procédé selon la revendication 1 ou 2,
**caractérisé par** le fait que le pas fixé vaut 1 LSB, 1 LSB étant le bit de poids le plus faible de la valeur correctrice respective.

4. Procédé selon l'une des revendications 1 à 3,
**caractérisé par** le fait qu'on met d'abord à zéro les valeurs correctrices, que le pas fixé est supérieur à 1 LSB pour un certain nombre d'opérations de calibrage et que le pas est ensuite égal à 1 LSB, 1 LSB étant le bit de poids le plus faible de la valeur correctrice respective.

5. Procédé selon l'une des revendications 1 à 4,
**caractérisé par** le fait que, pour une opération d'autocalibrage, on compare un signal caractéristique déduit d'un élément de référence à un signal formé à partir des éléments de référence de poids moindre en tenant compte du réseau correcteur commandé par la valeur correctrice pour l'élément de référence et qu'on modifie du pas fixé la valeur correctrice en fonction du résultat de comparaison.

6. Procédé selon l'une des revendications 2 à 4,
**caractérisé par** le fait que, pour une opération d'autocalibrage, on compare un signal déduit de la valeur correctrice prévue pour le calibrage d'offset à un signal déduit de l'offset momentanément présent et qu'on modifie du pas fixé la valeur correctrice en fonction du résultat de comparaison.

7. Procédé selon l'une des revendications précédentes,
**caractérisé par** le fait que le convertisseur fonctionne selon le principe de la redistribution de charges avec approximation successive et contient un réseau principal de capacités (1) pondéré en binaire et un réseau correcteur de capacités (2) pondéré en binaire.
